# EUROPEAN PATENT APPLICATION

(11) **EP 4 325 229 A1**
(43) Date of publication of application: **21.02.2024**
(21) Application number: 22190849.4
(22) Date of filing: 17.08.2022
(51) Int. Cl.: G01R 31/312

(54) **METHOD AND APPARATUS FOR CONTACTLESS INSPECTION OF A SUBSTRATE**

(71) Applicant: ASML Netherlands B.V., 5500 AH Veldhoven (NL)
(72) Inventor: RAVICHANDRAN, Arvind, 5500 AH Veldhoven (NL); PARAYIL VENUGOPALAN, Syam, 5500 AH Veldhoven (NL)
(74) Representative: ASML Netherlands B.V.

(57) **Abstract**

A device (201) for inspecting a conductive pattern (202) on a substrate (200) includes a plurality of sensor plates (204), a table configured and arranged to support the substrate , a voltage source (208), configured to generate an electric field between the sensor plates and the conductive pattern on the substrate, an actuator (206), configured to move the sensor plates relative to the substrate, a controller (210), the controller configured and arranged to identify regions having defect on the basis of changes in capacitance between the sensor plates and the substrate as the sensor plates are moved relative to the substrate.

## Description

### FIELD

The description herein relates generally to systems and methods for inspecting structures on a substrate. More particularly, it relates to the use of electric fields to identify regions in which defects are likely to exist.

### BACKGROUND

A lithography apparatus can be used, for example, in the manufacture of integrated circuits (ICs). In such a case, a patterning device (e.g., a mask) may contain or provide a device pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern of the patterning device. In general, a single substrate contains a plurality of adjacent target portions to which the pattern is transferred successively by the lithography apparatus, one target portion at a time. In one type of lithography apparatus, the pattern of the entire patterning device is transferred onto one target portion in one go; such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern of the patterning device are transferred to one target portion progressively. Since, in general, the lithography apparatus will have a magnification factor M (generally < 1), the speed F at which the substrate is moved will be a factor M times that at which the projection beam scans the patterning device.

Prior to transferring the pattern from the patterning device to the substrate, the substrate may undergo various procedures, such as priming, resist coating and a soft bake. After exposure, the substrate may be subjected to other procedures, such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemical-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern of the patterning device to a substrate and typically, but optionally, involves one or more related pattern processing steps, such as resist development by a development apparatus, baking of the substrate using a bake tool, etching using the pattern using an etch apparatus, etc.

These manufacturing processes are subject to various errors in any one of the several steps. As a result, it is useful to be able to examine a manufactured structure to determine whether there are defects that may affect the operation of the finished product. Such examination may take place at any of several steps in the process. A method of characterizing defects prior to a final electrical test phase can help to reduce the cycle time between identifying an issue and making appropriate corrections to process steps.

### SUMMARY

In an embodiment, a device for inspecting a conductive pattern on a substrate includes a plurality of sensor plates, a table configured and arranged to support the substrate, a voltage source, configured to generate an electric field between the sensor plates and the conductive pattern on the substrate, an actuator, configured to move the sensor plates relative to the substrate, a controller, the controller configured and arranged to identify regions having defect on the basis of changes in capacitance between the sensor plates and the substrate as the sensor plates are moved relative to the substrate.

In an embodiment, a method of A method of inspecting a conductive pattern on a substrate includes applying a voltage to a plurality of sensor plates and an opposing voltage to the conductive pattern, generating an electric field therebetween, relatively scanning the plurality of sensor plates with respect to the substrate, during the relatively scanning, measuring changes in capacitance between the sensor plates and the substrate, and identifying regions of the conductive pattern having defects on the basis of the measured changes in capacitance.

In an embodiment, there is provided a computing system including a processor and a memory, and including a non-transitory machine readable medium including instructions for performing the foregoing method.

In an embodiment, there is provided a computer program product including a computer non-transitory readable medium having instructions recorded thereon, the instructions when executed by a computer implementing the foregoing method.

### BRIEF DESCRIPTION OF THE DRAWINGS

Figure 1 illustrates a schematic diagram of a lithography apparatus;
Figure 2 depicts an embodiment of a lithographic cell or cluster;
Figure 3a illustrates a prior art design/inspection/production cycle for lithographic manufacture of a device, and Figure 3b illustrates an alternate design/inspection/production cycle in accordance with an embodiment;
Figure 4 is a schematic illustration of an embodiment of an inspection device in accordance with an embodiment;
Figure 5 is an illustration of a scanning pattern for an array of sensors in accordance with an embodiment; and
Figure 6 is a flowchart illustrating a process in accordance with an embodiment.

### DETAILED DESCRIPTION OF THE DRAWINGS

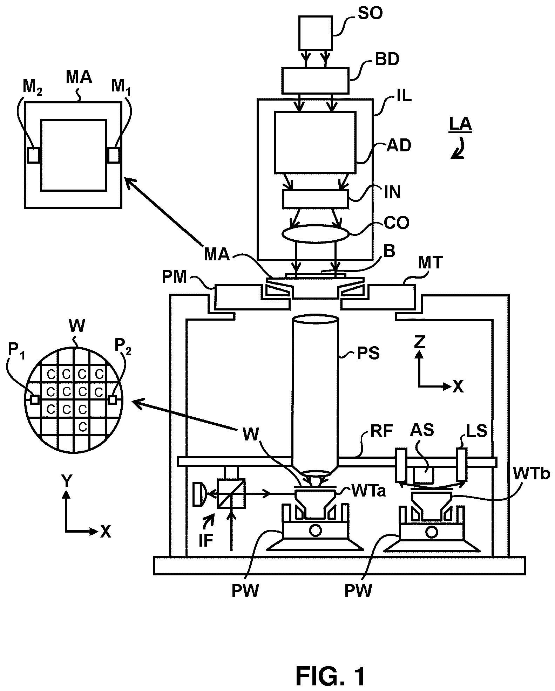

Figure 1 schematically depicts a lithographic apparatus LA in association with which the techniques described herein can be utilized. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; one or more substrate tables (e.g., a wafer table) WTa, WTb constructed to hold a substrate (e.g., a resist coated wafer) W and connected to a second positioner PW configured to accurately position the substrate in accordance with certain parameters; and a projection optical system (e.g., a a refractive, catoptric or catadioptric optical system) PS configured to project a pattern imparted to the radiation beam B by patterning device MA onto a target portion C (e.g., including one or more dies) of the substrate W.

The illumination optical system may include various types of optical components, such as refractive, reflective, magnetic, electromagnetic, electrostatic or other types of optical components, or any combination thereof, for directing, shaping, or controlling radiation. In this particular case, the illumination system also comprises a radiation source SO.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive patterning device). However, the apparatus may be of a reflective type (e.g., employing a programmable mirror array of a type as referred to above, or employing a reflective mask). The apparatus may employ a different kind of patterning device to classic mask; examples include a programmable mirror array or LCD matrix.

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO (e.g., a mercury lamp or excimer laser, LPP (laser produced plasma) EUV source). The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the spatial and/or angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table) MT, and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using patterning device alignment marks M₁, M₂ and substrate alignment marks P₁, P₂. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the patterning device alignment marks may be located between the dies. Small alignment markers may also be included within dies, in amongst the device features, in which case it is desirable that the markers be as small as possible and not require any different imaging or process conditions than adjacent features. The alignment system, which detects the alignment markers, is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS, measuring the position of alignment markers on the substrate using an alignment sensor AS, performing any other type of metrology or inspection, etc. This enables a substantial increase in the throughput of the apparatus. More generally, the lithography apparatus may be of a type having two or more tables (e.g., two or more substrate tables, a substrate table and a measurement table, two or more patterning device tables, etc.). In such "multiple stage" devices a plurality of the multiple tables may be used in parallel, or preparatory steps may be carried out on one or more tables while one or more other tables are being used for exposures. Twin stage lithography apparatuses are described, for example, in U.S. Patent No. 5,969,441, incorporated herein by reference in its entirety.

While a level sensor LS and an alignment sensor AS are shown adjacent substrate table WTb, it will be appreciated that, additionally or alternatively, a level sensor LS and an alignment sensor AS can be provided adjacent the projection system PS to measure in relation to substrate table WTa.

The depicted apparatus can be used in a variety of modes, including for example a step mode or a scan mode. The construction and operation of lithographic apparatus is well known to those skilled in the art and need not be described further for an understanding of the embodiments of the present invention.

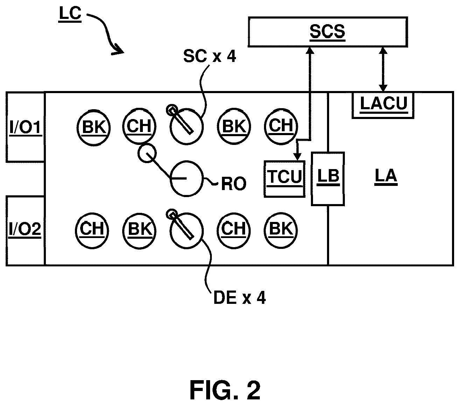

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

The patterning device referred to above comprises, or can form, one or more design layouts or patterns (hereinafter design pattern for convenience). The design pattern can be generated utilizing CAD (computer-aided design) programs, this process often being referred to as EDA (electronic design automation). Most CAD programs follow a set of predetermined design rules in order to create functional design patterns/patterning devices. These rules are set by processing and design limitations. For example, design rules define the space tolerance between circuit devices (such as gates, capacitors, etc.) or interconnect lines, so as to ensure that the circuit devices or lines do not interact with one another in an undesirable way. One or more of the design rule limitations may be referred to as "critical dimensions" (CD). A critical dimension of a circuit can be defined as the smallest width of a line or hole or the smallest space between two lines or two holes. Thus, the CD determines the overall size and density of the designed circuit. Of course, one of the goals in integrated circuit fabrication is to faithfully reproduce the original circuit design on the substrate (via the patterning device).

The illumination system provides illumination (i.e., radiation) in the form of an illumination mode to a patterning device and the projection system directs and shapes the illumination, via the patterning device, onto a substrate via aerial image (AI). The illumination mode defines the characteristics of the illumination, such as the angular or spatial intensity distribution (e.g., conventional, dipole, annular, quadrupole, etc.), an illumination sigma (σ) setting, etc. The aerial image (AI) is the radiation intensity distribution at substrate level. A resist layer on the substrate is exposed and the aerial image is transferred to the resist layer as a latent "resist image" (RI) therein. The resist image (RI) can be defined as a spatial distribution of solubility of the resist in the resist layer.

A set of conditions for imaging can be considered, and of the total set of possible conditions, a process window of a pattern is a space in that set of conditions in which processing parameters for producing the pattern are such that satisfactory imaging of the pattern is achieved. That is, for a given pattern, there may be a set of values of depth of focus, illumination intensity, illumination pattern, numerical aperture, and other controllable variables produce images having sufficiently good imaging of lines or features including linewidth, pitch, or other aspects of the imaged pattern that are defined as meeting the specifications for the required imaging. The process window gives an indication of the process sensitivity to variations in input parameters such as radiation dose.

Processing parameters are parameters of the patterning process. The patterning process may include processes upstream and downstream to the actual lithographic transfer of the pattern. Processing parameters may belong to a number of categories. A first category may be parameters of the lithography apparatus or any other apparatuses used in the patterning process. Examples of this category include parameters of the illumination system, projection system, substrate stage, etc. of a lithography apparatus. A second category may be parameters of any procedures performed in the patterning process. Examples of this category include focus, dose, bandwidth, exposure duration, development temperature, chemical compositions used in development, etc. A third category may be parameters of the design pattern. Examples of this category may include resolution enhancement technique (RET) or optical proximity correction adjustments such as shapes and/or locations of assist features. A fourth category may be parameters of the substrate. Examples include characteristics of structures under a resist layer, chemical composition of the resist layer, and/or physical dimensions of the resist layer. A fifth category may be parameters that represent a characteristic of temporal variation of one or more parameters of the patterning process. Examples of this category may include a characteristic of high frequency stage movements (e.g., frequency, amplitude, etc.), a high frequency laser bandwidth change (e.g., frequency, amplitude, etc.) and/or a high frequency laser wavelength change. These high frequency changes or movements are those above the response time of a mechanism to adjust the underlying parameter (e.g., stage position, laser intensity, etc.). A sixth category may be a characteristic upstream or downstream to exposure, such as post-exposure bake (PEB), development, etching, deposition, resist application, doping and/or packaging.

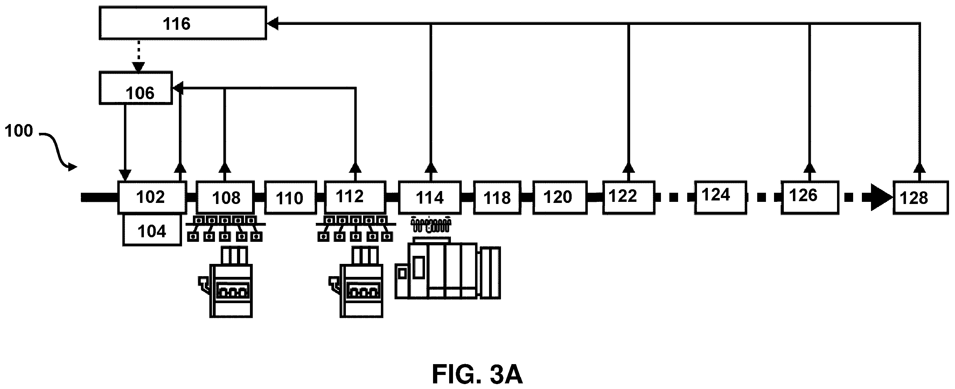

Figure 3a illustrates a workflow 100 for a chip manufacturing process. In particular, it represents a design/inspection/production cycle for a particular process or recipe. The lithography step 102, as described above, involves printing a pattern onto a substrate. This step includes a metrology aspect 104, in that the alignment sensor AS and level sensor LS (shown in Figure 1) provide feedback to the imaging process. This metrology 104 can provide information back to an advanced process control (APC) module 106, which can adjust recipes on the fly in order to improve imaging performance. Because the APC 106 can react during printing of a wafer batch, or between batches, the cycle time for making processing improvements is on the order of minutes or less.

Once an image is formed, a metrology tool performs an inspection step 108. For example, this may be an after-develop inspection (ADI) tool. One such tool is an optical metrology tool such as YieldStar, which may be integrated into the lithography cluster. Feedback to the APC 106 from this inspection step 108 takes place on the order of minutes or hours.

The developed image is then etched 110, and another optical metrology step 112 may be performed. Again, this may be a YieldStar after etch inspection, for example. The feedback time frame for this step is on the order of hours or a day.

A next step inspection may be, for example, an e-beam inspection 114. E-beam inspection is relatively slow, so it may be applied only to particular critical regions of the wafer. Moreover, it is not generally integrated with the APC 106, but rather feeds back into an overall fabrication monitoring system 116. This feedback process proceeds on a similar time frame as the second optical metrology step 112, i.e., hours to a day.

Next, fill 118 and chemical-mechanical processing 120 steps are performed. After this, an inspection 122 using e-beam or similar technology can be performed. Manufacturers would prefer to be able to identify electrical failures and characterize transistors at this post-CMP stage, because this provides them with a relatively early indication of what the final yield will be. However, e-beam techniques are quite slow, and extensive e-beam testing at this stage is not generally acceptable within the workflow. In order to minimize the effect on throughput, typically only sparse measurements are taken at this stage. The cycle time for this metrology step is on the order of days or weeks, but typically will not identify all electrical failures due to the requirement that it involve only sparse measurements.

One or more metallization steps 124 are performed, after which a full electrical test (eTest) 126 can be performed. This testing can identify electrical defects thoroughly, but it has the drawback of being a weeks-long cycle. Finally, yield testing 128 is performed. As indicated by the dashed lines in Figure 3a, there may be additional intermediate steps between the illustrated ones. Yield testing 128 has a cycle time on the order of months. As will be appreciated, it would be useful to develop an inspection process for identifying electrical defects on a shorter cycle time than weeks or months, and for such inspection process to have a higher throughput than e-beam inspection does.

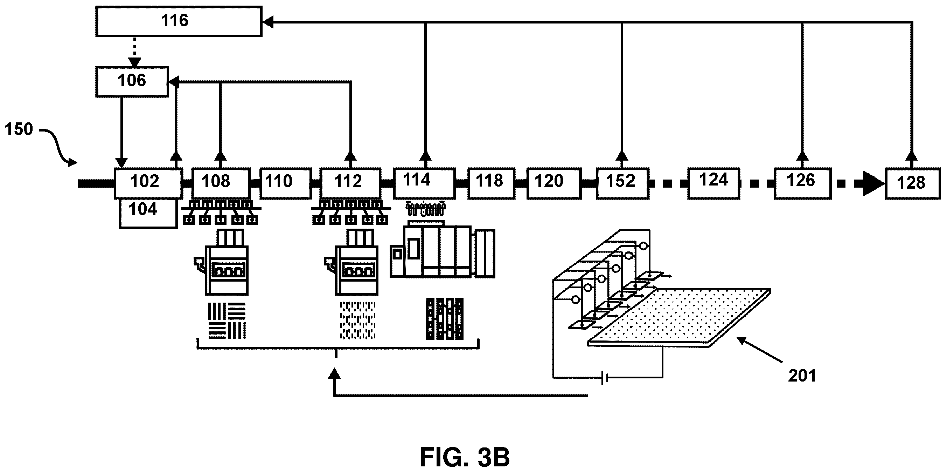

Figure 3b illustrates a workflow 150 for a chip manufacturing process that is similar to the workflow 100 of Figure 3a, but including a novel inspection step. The lithography step 102, as described above, involves printing a pattern onto a substrate. This step includes a metrology aspect 104, in that the alignment sensor AS and level sensor LS (shown in Figure 1) provide feedback to the imaging process. This metrology 104 can provide information back to an advanced process control (APC) module 106, which can adjust recipes on the fly in order to improve imaging performance. Because the APC 106 can react during printing of a wafer batch, or between batches, the cycle time for making processing improvements is on the order of minutes or less.

Once an image is formed, a metrology tool performs an inspection step 108. For example, this may be an after-develop inspection (ADI) tool. One such tool is an optical metrology tool such as YieldStar, which may be integrated into the lithography cluster. Feedback to the APC 106 from this inspection step 108 takes place on the order of minutes or hours.

The developed image is then etched 110, and another optical metrology step 112 may be performed. Again, this may be a YieldStar after etch inspection, for example. The feedback time frame for this step is on the order of hours or a day.

A next step inspection may be, for example, an e-beam inspection 114. E-beam inspection is relatively slow, so it may be applied only to particular critical regions of the wafer. Moreover, it is not generally integrated with the APC 106, but rather feeds back into an overall fabrication monitoring system 116. This feedback process proceeds on a similar time frame as the second optical metrology step 112, i.e., hours to a day.

Next, fill 118 and chemical-mechanical processing 120 steps are performed. After this, an electrical inspection 152 is performed using a device in accordance with an embodiment, as described in greater detail below.

One or more metallization steps 124 are performed, after which a full electrical test (eTest) 126 can be performed. Finally, yield testing 128 is performed. As indicated by the dashed lines in Figure 3b, there may be additional intermediate steps between the illustrated ones. Yield testing 128 has a cycle time on the order of months.

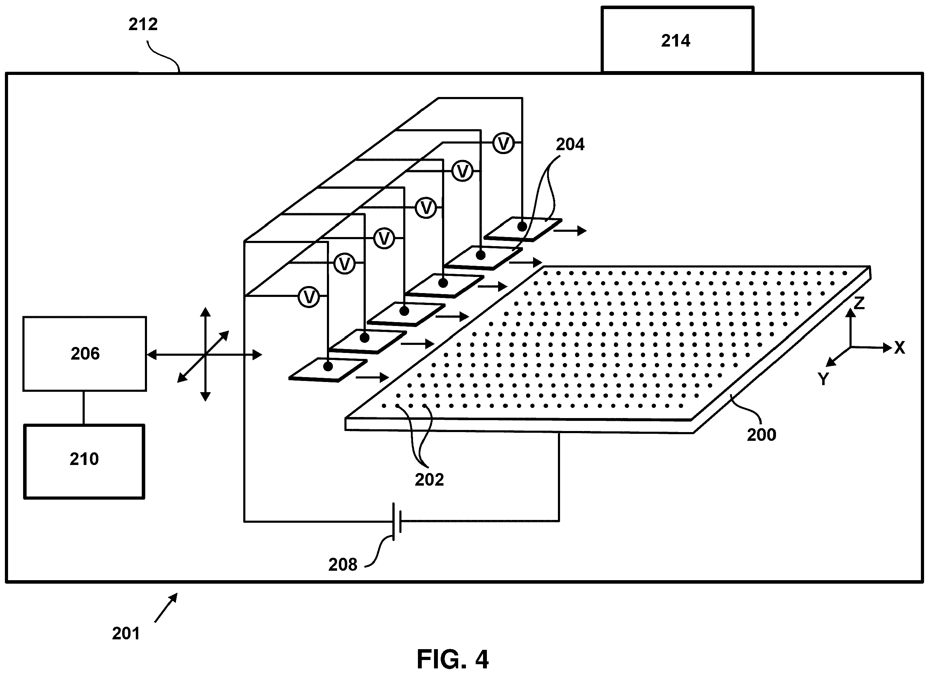

Referring now to Figure 4, a substrate 200 to be inspected using an apparatus 201 in accordance with an embodiment contains an array of conductive features 202. This substrate 200 may be, for example, a wafer with several dies, a single die on a wafer, or a die that has been diced from a wafer.

Above the substrate 200 is an array of sensor plates 204. In principal, a single sensor plate could be used, but as will be discussed further below, the use of an array as pictured in the Figure 4 allows for improved throughput in the inspection device. The substrate 200 is clamped to a stationary table (not illustrated). While a stationary table is sufficient, there is no requirement that the table be stationary, and indeed any system by which the sensor plates 204 and the substrate 200 can be relatively scanned can be used including one in which the substrate 200 is held on a movable stage. The sensor plates 204 are mechanically linked so that they can, as a unit, be actuated in x, y and z, by an actuator 206, such that all the sensor plates move in unison in the three axes. Embodiments may further include a six degree of freedom actuator to allow for rotations about the three axes. The actuator 206 may be of any suitable type, such as a linear motor array, for example. In an embodiment, the sensor plates 204 are mounted to a movable stage (not shown). The movable stage may also be operatively coupled to an interferometer or other device for determining an accurate position of the movable stage as it is scanned over the substrate 200. The relative scanning may be stepwise, continuous, or a combination of stepwise and continuous relative motion.

Furthermore, in an embodiment, the individual plates may be relatively tilted or moved to account for wafer topography. In this approach, a topography measurement step may be included and the individual plates may be manipulated in up to six degrees of freedom to follow height variation of the substrate surface.

In use, the controller 210 receives the measurement signal and performs appropriate comparisons to identify defect locations. Alternately, the controller 210 can transmit the measured signals for remote processing and defect localization.

In an embodiment, the substrate contains multiple conductive features 202, such as metallic vias, on its surface. The sensor plates 204 are conducting plates, and can have a voltage applied via a voltage source 208. In an example, the dimension of the smallest vias on the substrate is around 20 nm, with a typical pitch of around 40 nm in x and y. The dimension of the sensor plate may be, for example, about 40 µm x 40 µm. In this particular arrangement, 1000 conductive features 202 will fall into the footprint of each sensor plate. In another embodiment, the area may be such that 100 vias fall into the footprint of the sensor plate. As will be appreciated, where a full wafer is to be inspected, the plates may be scaled accordingly, or the scan time may be increased to ensure full coverage.

During operation, the sensor plates 204 and the substrate 200 are separated by an air gap, which may be, for example, less than about 100 µm. The voltage supply provides an opposite charge to the conductive features 202 as to the sensor plates, which creates an accumulation of charge on each of the features and on the plates.

The controller 210, may further be configured to control the actuation of the sensor plates 204. By actuating the sensor plates 204 in z, the distance between the sensor plates 204 and the substrate 200 may be kept at 100 µm or less. This allows for the electric fields from the conductive features 202 to interact individually with the plates 204. The capacitance between the sensor plates and the substrate will capture the aligned positions of the metallic vias.

If there are more or fewer conductive features (or if the features have an incorrect area), the capacitance will be different from what is expected. In this regard, prior to measurement, the capacitance may be modeled in order to determine an expected capacitance value for each sensor plate. The deviation of measured capacitance from the expected capacitance can be a proxy for the non-contacting vias which is an early indication of the yield. The voltage of the power supply may be DC with a magnitude of 1000 V or less.

In an embodiment, the controller maintains a constant voltage across the circuit and the deviation of measured current from the expected current is taken as a proxy for the non-contacting vias and hence an early indicator of yield .

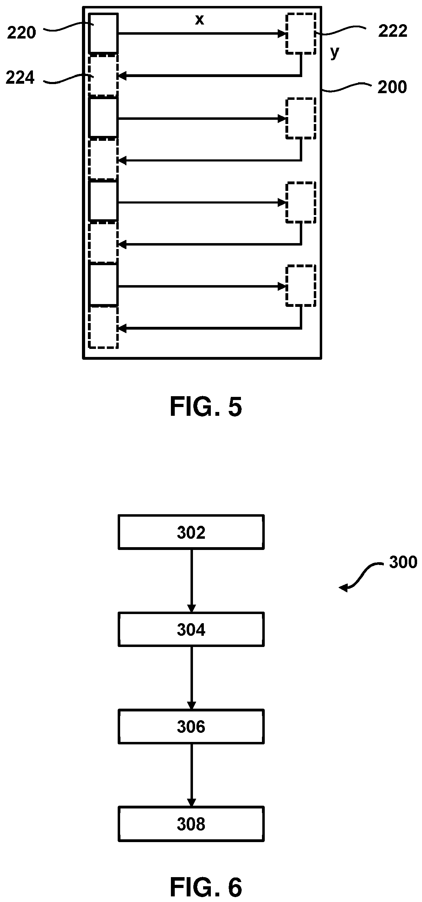

The use of an array of plates 204, each providing an independent capacitance measurement allows for relatively rapid measurements of a large area. The sensor plates 204 may be scanned across the substrate 200 in a pattern as illustrated in Figure 5. Each plate 204 has an extent in the y direction equal to the extent in y of the substrate 200 divided by two times the number of plates. Thus, within two strokes (one in a positive x-direction and the other in a negative x-direction), the sensor plate footprints will completely cover the entire substrate.

In an embodiment, the apparatus 201 further may include a vacuum chamber 212 to reduce risk of dielectric breakdown due to the voltages between the plates and the substrate. The vacuum chamber may include a load-lock 214.

In an embodiment in which the array of plates 204 includes gaps between plates, a step and scan type inspection may be performed. As illustrated in Figure 5, a representative plate begins at a starting zone 220, and scans across the substrate 200 in the x-direction arriving at a first landing zone 222. After displacing by its own width in the y-direction, the plate scans back across in the -x-direction, to a second landing zone 224. That is, the plates are moved in a first direction, then displaced in a second direction, perpendicular and co-planar with the first direction, then in a third direction, opposite to the first direction, such that the scans in the first and third directions cover an entire area of a die under inspection on the substrate. For embodiments in which the plates are scaled as described above, the two movements will completely scan the substrate 200. In principle, a single plate could cover the same area using multiple scans, at a cost of throughput.

For the sensor plates 204, capacitance as a function of sensor plate position is measured, and compared against an expected value by the controller or processor. The expected value may be determined by modeling, or by comparison against a reference die, for example. Where a reference die is used, it may be useful to perform multiple measurements and make use of average values. These measurements may provide information about whether and where there are defects in the conductive features such as misalignment, misplacement, improper formation (for example size), and/or failure for a via to connect properly to the voltage source on the backside of the substrate 200.

In an embodiment, a tool may include two sets of sensor plates 204. A first set of plates is larger than a second set of plates (not shown in the Figures). The larger plates provide a coarse measurement in which particular regions of the substrate 202 may be identified as requiring further inspection. Then the smaller plates are used to measure the location of defects more accurately, i.e., to localize them within a sub-region of the identified region. In this approach, the smaller plates may be one or two orders of magnitude smaller in area than the large plates.

A method of inspection 300 is illustrated in the flowchart of Figure 6. Initially, at step 302, a voltage is applied to a plurality of sensor plates and an opposing voltage is applied to the conductive pattern to generate an electric field therebetween. Next, while the voltage is maintained, the sensor plates are relatively scanned at step 304 over the substrate. During the scanning, changes in capacitance between the sensor plates and the conductive pattern are measured in step 306. This measurement may be continuous monitoring, or may involve sampling at a selected time or distance interval. Finally, regions of the conductive pattern having defects are identified in step 308 on the basis of the measured changes in capacitance.

Embodiments may include computer readable medium programmed with instructions, which when executed, perform any of the methods described herein. Furthermore, aspects of the present application may take the form of a computer program product embodied in any one or more physical computer readable medium(s) having computer usable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, device, or any suitable combination of the foregoing. More specific examples (a non-exhaustive list) of the computer readable medium would include the following: an electrical connection having one or more wires, a portable computer diskette, a hard disk, a random access memory (RAM), a read-only memory (ROM), an erasable programmable read-only memory (e.g. EPROM or Flash memory), an optical fiber, a portable compact disc read-only memory CDROM, an optical storage device, a magnetic storage device, or any suitable combination of the foregoing. In the context of this document, a computer readable storage medium may be any tangible medium that can contain or store a program for use by or in connection with an instruction execution system, apparatus, or device.

The computer program instructions may also be loaded onto a computer, other programmable data processing apparatus, or other devices to cause a series of operational steps to be performed on the computer, other programmable apparatus, or other devices to produce a computer implemented process such that the instructions which execute on the computer or other programmable apparatus provide processes for implementing the functions/acts specified in the flowchart and/or block diagram block or blocks.

A data processing system suitable for storing and/or executing program code will include at least one processor coupled directly or indirectly to memory elements through a system bus. The memory elements can include local memory employed during actual execution of the program code, bulk storage, and cache memories which provide temporary storage of at least some program code in order to reduce the number of times code must be retrieved from bulk storage during execution.

Input/output or I/O devices (including but not limited to keyboards, displays, pointing devices, etc.) can be coupled to the system either directly or through intervening I/O controllers. Network adapters may also be coupled to the system to enable the data processing system to become coupled to other data processing systems or remote printers or storage devices through intervening private or public networks. Modems, cable modems and Ethernet cards are just a few of the currently available types of network adapters.

The description of the present application has been presented for purposes of illustration and description, and is not intended to be exhaustive or limited to the invention in the form disclosed. Many modifications and variations will be apparent to those of ordinary skill in the art. The embodiment was chosen and described in order to best explain the principles of the invention, the practical application, and to enable others of ordinary skill in the art to understand the invention for various embodiments with various modifications as are suited to the particular use contemplated.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid crystal display panels, thin film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

Embodiments also include the following numbered clauses:
Clause 1: an apparatus for inspecting a conductive pattern on a substrate, comprising:
   at least one sensor plate;
   a table configured and arranged to support the substrate;
   a voltage source, configured to generate an electric field between the at least one sensor plate and the conductive pattern on the substrate;
   an actuator, configured for relative movement between the at least one sensor plate and the substrate;
   a controller, the controller configured and arranged to identify regions having defect on the basis of changes in capacitance between the at least one sensor plate and the substrate during the relative movement between the at least one sensor plate and the substrate.
Clause 2: an apparatus as in clause 1, wherein each sensor plate has an area greater than 100 times an area of a representative feature in the conductive pattern to be inspected.
Clause 3: an apparatus as in either of clauses 1 to 2, further comprising at least one fine-measurement sensor plate, the fine-measurement sensor plate having an area smaller than an area of the sensor plate of the at least one sensor plate, the at least one fine-measurement sensor plate being operable to identify sub-regions within each of the regions having defects in which the defects are located on the basis of changes in capacitance between the at least one fine-measurement sensor plate and the substrate during the relative movement between the at least one fine-measurement sensor plate and the substrate.
Clause 4: an apparatus as in any of clauses 1 to 3, wherein the actuator is configured to move the sensor plates relative to the substrate in a first direction, displace the sensor plates in a second direction, perpendicular and co-planar with the first direction, then move the sensor plates relative to the substrate in a third direction, opposite to the first direction, such that the scans in the first and third directions cover an entire area of a die under inspection on the substrate.
Clause 5: an apparatus as in any of clauses 1 to 4, wherein the apparatus is configured to measure the capacitance substantially continuously during relative movement between the sensor plates and the substrate.
Clause 6: an apparatus as in any of clauses 1 to 5, wherein the table includes a clamp configured and arranged to hold the substrate during measurements.
Clause 7: an apparatus as in any of clauses 1 to 6, wherein the actuator allows relative movement between the plurality of sensor plates and the substrate in three mutually perpendicular dimensions.
Clause 8: an apparatus as in clause 7, wherein the actuator further allows relative rotation about the three mutual perpendicular dimensions.
Clause 9: an apparatus as in any of clauses 1 to 8, wherein the at least one sensor plate comprises a plurality of sensor plates, and each sensor plate is held in fixed relation to each of the other sensor plates of the plurality of sensor plates.
Clause 10: an apparatus as in any of clauses 1 to 9, wherein a region having a defect is determined by comparing a measured capacitance to an expected capacitance.
Clause 11: an apparatus as in clause 10, wherein the expected capacitance is derived from a measurement of a reference substrate or from a model.
Clause 12: an apparatus as in any of clauses 1 to 11, wherein relative movement between the at least one sensor plate and the substrate comprises moving in a continuous fashion.
Clause 13: an apparatus as in any of clauses 1 to 11, wherein relative movement between the at least one sensor plate and the substrate comprises moving in a step-wise fashion.
Clause 14: an apparatus as in any of clauses 1 to 11, wherein relative movement between the at least one sensor plate and the substrate comprises moving in a combination of a step-wise and a continuous fashion.
Clause 15: a method of inspecting a conductive pattern on a substrate, comprising:
   applying a voltage to a plurality of sensor plates and an opposing voltage to the conductive pattern, generating an electric field therebetween;
   relatively scanning the plurality of sensor plates with respect to the substrate;
   during the relatively scanning, measuring changes in capacitance between the sensor plates and the substrate; and
   identifying regions of the conductive pattern having defects on the basis of the measured changes in capacitance.
Clause 16: a method as in clause 15, wherein the relatively scanning the plurality of sensor plates comprises moving the sensor plates relative to the substrate in a first direction, displacing the sensor plates in a second direction, perpendicular and co-planar with the first direction, then moving the sensor plates relative to the substrate in a third direction, opposite to the first direction, such that the scans in the first and third directions cover an entire area of a die under inspection on the substrate.
Clause 17: a method as in any of clauses 15 to 16, wherein the capacitance is measured continuously during relative movement between the sensor plates and the substrate.
Clause 18: a method as in any of clauses 15 to 17, wherein the identifying regions of the conductive pattern having defects comprises comparing the measured changes in capacitance to respective expected capacitances.
Clause 19: a method as in clause 18, further comprising, deriving the expected capacitances from a measurement of a reference substrate.

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

The descriptions above are intended to be illustrative, not limiting. Thus, it will be apparent to one skilled in the art that modifications may be made as described without departing from the scope of the claims set out below.

## Claims

1. An apparatus for inspecting a conductive pattern on a substrate, comprising:
at least one sensor plate;
a table configured and arranged to support the substrate;
a voltage source, configured to generate an electric field between the at least one sensor plate and the conductive pattern on the substrate;
an actuator, configured for relative movement between the at least one sensor plate and the substrate;
a controller, the controller configured and arranged to identify regions having defect on the basis of changes in capacitance between the at least one sensor plate and the substrate during the relative movement between the at least one sensor plate and the substrate.

2. An apparatus as in claim 1, wherein each sensor plate has an area greater than 100 times an area of a representative feature in the conductive pattern to be inspected.

3. An apparatus as in claim 1, further comprising at least one fine-measurement sensor plate, the fine-measurement sensor plate having an area smaller than an area of the sensor plate of the at least one sensor plate, the at least one fine-measurement sensor plate being operable to identify sub-regions within each of the regions having defects in which the defects are located on the basis of changes in capacitance between the at least one fine-measurement sensor plate and the substrate during the relative movement between the at least one fine-measurement sensor plate and the substrate.

4. An apparatus as in claim 1, wherein the actuator is configured to move the sensor plates relative to the substrate in a first direction, displace the sensor plates in a second direction, perpendicular and co-planar with the first direction, then move the sensor plates relative to the substrate in a third direction, opposite to the first direction, such that the scans in the first and third directions cover an entire area of a die under inspection on the substrate.

5. An apparatus as in claim 1, wherein the apparatus is configured to measure the capacitance substantially continuously during relative movement between the sensor plates and the substrate.

6. An apparatus as in claim 1, wherein the table includes a clamp configured and arranged to hold the substrate during measurements.

7. An apparatus as in claim 1, wherein the actuator allows relative movement between the plurality of sensor plates and the substrate in three mutually perpendicular dimensions.

8. An apparatus as in claim 7, wherein the actuator further allows relative rotation about the three mutual perpendicular dimensions.

9. An apparatus as in claim 1, wherein the at least one sensor plate comprises a plurality of sensor plates, and each sensor plate is held in fixed relation to each of the other sensor plates of the plurality of sensor plates.

10. An apparatus as in claim 1, wherein a region having a defect is determined by comparing a measured capacitance to an expected capacitance.

11. An apparatus as in claim 10, wherein the expected capacitance is derived from a measurement of a reference substrate or from a model.

12. An apparatus as in claim 1, wherein relative movement between the at least one sensor plate and the substrate comprises moving in a continuous fashion.

13. An apparatus as in claim 1, wherein relative movement between the at least one sensor plate and the substrate comprises moving in a step-wise fashion.

14. An apparatus as in claim 1, wherein relative movement between the at least one sensor plate and the substrate comprises moving in a combination of a step-wise and a continuous fashion.

15. A method of inspecting a conductive pattern on a substrate, comprising:
applying a voltage to a plurality of sensor plates and an opposing voltage to the conductive pattern, generating an electric field therebetween;
relatively scanning the plurality of sensor plates with respect to the substrate;
during the relatively scanning, measuring changes in capacitance between the sensor plates and the substrate; and
identifying regions of the conductive pattern having defects on the basis of the measured changes in capacitance.
